# EUROPEAN PATENT APPLICATION

(11) **EP 4 468 374 A1**
(43) Date of publication of application: **27.11.2024**
(21) Application number: 23211523.8
(22) Date of filing: 22.11.2023
(51) Int. Cl.: H01L 31/05

(54) **PHOTOVOLTAIC MODULE**

(30) Priority: 23.05.2023 CN 202310596227; 23.05.2023 CN 202310596300
(71) Applicant: Zhejiang Jinko Solar Co., Ltd., Haining, Zhejiang 314416 (CN); JINKO SOLAR CO., LTD, ShangRao, Jiangxi 334100 (CN)
(72) Inventor: TAO, Wusong, ZHEJIANG, 314416 (CN); XU, Tao, ZHEJIANG, 314416 (CN); LI, Tingting, ZHEJIANG, 314416 (CN); CHEN, Shuping, ZHEJIANG, 314416 (CN); ZHANG, Rui, ZHEJIANG, 314416 (CN)
(74) Representative: DREISS Patentanwälte PartG mbB

(57) **Abstract**

Provided is a photovoltaic module. The photovoltaic module includes a plurality of solar cells connected by leads. The solar cells are arranged with a preset gap or are arranged overlapping with one another. A shape of the lead matches arrangement of the solar cells. The lead includes a flat section having a smaller thickness than other sections. The lead includes a flat section with smaller thickness, thereby reducing a damage risk of the solar cells and improving overall quality of the photovoltaic module.

## Description

### TECHNICAL FIELD

The present disclosure relates to the technical field of photovoltaic, and in particular, to a photovoltaic module.

### BACKGROUND

Solar energy is a renewable energy source. A photovoltaic module is a core part in a solar power generation system and is also the most important part in the solar power generation system. The function of the photovoltaic module is to convert solar energy into electrical energy and send the electrical energy to a storage battery for storage or push a load to operate. The photovoltaic module generally includes a front packaging structure, a back packaging structure, and a cell array. The cell array is formed by a plurality of solar cell strings connected in series or in parallel. Each solar cell string includes a plurality of solar cells arranged at intervals, and two adjacent solar cells are connected through a lead.

Conventionally, the lead has one end connected to a front surface of one solar cell and another end connected to a back surface of an adjacent solar cell. A middle part of the lead easily interferes with an end portion of the solar cell, causing a risk of damages to the end portion of the solar cell due to stress concentration.

### SUMMARY

The present disclosure provides a photovoltaic module.

According to one aspect, the photovoltaic module includes: a front packaging structure, a back packaging structure, and a cell array.

The front packaging structure includes a front plate and a front packaging layer. The back packaging structure includes a back plate and a back packaging layer. The cell array includes a plurality of solar cells. Each of the solar cells is rectangular and includes a front surface and a back surface opposite to each other. The cell array further includes leads. The lead has a first connection section, a flat section, and a second connection section arranged sequentially along a length direction of the photovoltaic module, the first connection section is connected to the front surface of one of adjacent solar cells, and the second connection section is connected to the back surface of the other one of the adjacent solar cells.

Along a thickness direction of the photovoltaic module, a thickness of the flat section is less than a thickness of either of the first connection section and the second connection section.

A cell distance L1 between two adjacent solar cells satisfies 0 mm<L1≤1 mm, and a first dimension L2 in the length direction of the photovoltaic module of the flat section satisfies 6≤L2:L1≤23.9, or the adjacent solar cells overlap each other to form an overlapping region, and a dimension of the flat section in the length direction of the photovoltaic module is greater than or equal to that of the overlapping region.

In some embodiments, along the thickness direction of the photovoltaic module, the thickness H1 of the flat section satisfies 0.05 mm≤H1<0.26 mm.

In some embodiments, a dimension of the flat section in a width direction of the photovoltaic module ranges from 2 mm to 20 mm.

In some embodiments, a dimension of the flat section in a width direction of the photovoltaic module ranges from 2 mm to 20 mm.

In some embodiments, the thickness of the first connection section and the thickness of the second connection section in the thickness direction of the photovoltaic module are both greater than or equal to 0.35 mm and less than or equal to 0.4 mm.

In some embodiments, along a width direction of the photovoltaic module, either a width of the first connection section or the second connection section is greater than or equal to 0.22 mm and less than 0.26 mm.

In some embodiments, each solar cell is a half-cut cell, and along the length direction of the photovoltaic module, and a length L3 of the solar cell satisfies: 95 mm≤L3≤110 mm, and along a width direction of the photovoltaic module, a width W2 of each solar cell satisfies 177 mm≤W2≤187 mm.

In some embodiments, along the thickness direction of the photovoltaic module, the thickness of the solar cell is H2, and H2 satisfies 80 µm≤H2≤125 µm.

In some embodiments, both the front plate and the back plate are made of glass, the photovoltaic module further includes a strip, and the strip includes a first strip and a second strip, and along the thickness direction of the photovoltaic module, the first strip is aligned with a gap between two solar cells adjacent in the length direction of the photovoltaic module, and the second strip is aligned with a gap between two solar cells adjacent in the width direction of the photovoltaic module.

In some embodiments, along the length direction of the photovoltaic module, the first strip has a second dimension L4, and a ratio L4:L1 satisfies: 5.38≤L4:L1≤6.25.

In some embodiments, the second dimension L4 and the first dimension L2 satisfy: L4<L2.

In some embodiments, along the thickness direction of the photovoltaic module, a thickness of the first strip is H3, and H3 satisfies 80 µm≤H3≤140 µm.

In some embodiments, along the thickness direction of the photovoltaic module, the strip includes a reflective layer, a base layer, and an adhesive layer arranged sequentially, and the adhesive layer is adhered to an inner surface of the back plate.

In some embodiments, each solar cell includes pads, and the first connection section and the second connection section are connected to the pads of adjacent solar cells.

In some embodiments, the plurality of solar cells overlap with one another, and a dimension L of the overlapping region in the length direction of the photovoltaic module satisfies 0<L≤1 mm.

In some embodiments, a side of the flat section in contact with the solar cell is a flat surface.

In some embodiments, 6 solar cells of the plurality of solar cells are arranged at intervals along the width direction of the photovoltaic module, and 11 or 12 solar cells of the plurality of solar cells are arranged overlapping with one another along the length direction of the photovoltaic module.

The present disclosure provides a photovoltaic module. The photovoltaic module includes solar cells and leads. Each of the solar cells is rectangular and has a dimension in a second direction greater than a dimension in a first direction. The solar cell includes a front surface and a back surface opposite to each other. Adjacent solar cells are connected by the lead. The lead has one end connected to the front surface of one of the adjacent solar cells and another end connected to the back surface of the other one of the adjacent solar cells. The lead includes a thinned section and connection sections located at two ends of the thinned section. A thickness of the thinned section is less than that of the connection section. Overlapping parts of the adjacent solar cells form an overlapping region, and a dimension of the thinned section in the length direction of the photovoltaic module is greater than or equal to that of the overlapping region, thereby reducing a damage possibility of the solar cells.

The present disclosure provides a photovoltaic module. The photovoltaic module includes solar cells and leads. The solar cells are arranged with a preset gap or are arranged overlapping with one another. A shape of the lead matches arrangement of the solar cells. The lead includes a flat section (thinned section) having a smaller thickness than other sections, thereby reducing a damage possibility of the solar cells and improving overall quality of the photovoltaic module.

It should be understood that the general description above and the detailed description in the following are merely exemplary and illustrative, and cannot limit the present disclosure.

### BRIEF DESCRIPTION OF DRAWINGS

FIG. 1 is a schematic a cross-sectional view of a photovoltaic module according to some embodiments of the present disclosure;
FIG. 2 is a schematic structural diagram of a cell array in FIG. 1;
FIG. 3 is a schematic cross-sectional view of a partial structure in FIG. 1;
FIG. 4 is a schematic structural diagram of a lead in FIG. 3 from one perspective;
FIG. 5 is a schematic structural diagram of the lead in FIG. 4 from another perspective;
FIG. 6 is a schematic cross-sectional view of the photovoltaic module according to some embodiments of the present disclosure;
FIG. 7 is a schematic structural diagram of an inner surface of a back plate in FIG. 6;
FIG. 8 is a schematic cross-sectional view of a partial structure in FIG. 6;
FIG. 9 is a schematic structural diagram of a first strip in FIG. 8;
FIG. 10 is a schematic cross-sectional view of a partial structure in FIG. 6;
FIG. 11 is a schematic structural diagram of a photovoltaic module according to some embodiments of the present disclosure;
FIG. 12 is a schematic structural diagram of a lead in FIG. 11;
FIG. 13 is a schematic structural diagram of a solar cell according to some embodiments of the present disclosure;
FIG. 14 is a schematic cross-sectional view of a connection section according to the present disclosure;
FIG. 15 is a schematic cross-sectional view of a flat section according to the present disclosure; and
FIG. 16 is a schematic structural diagram of a photovoltaic module according to some embodiments of the present disclosure from another perspective.

Reference signs:
1: front plate;
2: front packaging layer;
3: cell array;
   31: solar cell string;
      311: solar cell;
      311a: edge pad;
   32: lead;
      321: first connection section;
      322: flat section;
      323: second connection section;
   33: pad;
4: back packaging layer;
5: back plate;
6: strip;
   601: reflective layer;
   602: base layer;
   603: adhesive layer;
   61: first strip;
   62: second strip.

The accompanying drawings are incorporated in this specification and constitute a part of this specification, illustrate embodiments and principles of the present disclosure together with the specification.

### DESCRIPTION OF EMBODIMENTS

In order to better understand the technical solutions of the present disclosure, embodiments of the present disclosure will be described in detail below in conjunction with the accompanying drawings.

It should be clear that the described embodiments are only some rather than all of the embodiments of the present disclosure. Based on the embodiments in the present disclosure, all other embodiments obtained by those of ordinary skill in the art without creative efforts fall within the protection scope of the present disclosure.

Terms used in the embodiments of the present disclosure are only for the purpose of describing specific embodiments, and are not intended to limit the present disclosure. Singular forms of "a/an", "the", and "said" used in the embodiments of the present disclosure and the appended claims are intended to include plural forms, unless otherwise clearly specified in the context.

It should be understood that the term "and/or" used herein describes an association relationship between associated objects and represents that three relationships may exist. For example, A and/or B may represent the following three cases: only A exists, both A and B exist, and only B exists. In addition, the character "/" herein generally indicates an "or" relationship between the associated objects.

It is to be noted that orientation terms such as "up", "down", "left", and "right" described in the embodiments of the present disclosure are described from the perspective shown in the accompanying drawings, and should not be construed as limiting the embodiments of the present disclosure. Besides, in this context, it is to be further understood that one element described as being connected "on" or "under" another element not only means that the element may be directly connected "on" or "under" the another element, but also means that the element may be indirectly connected "on" or "under" the another element through an intermediate element.

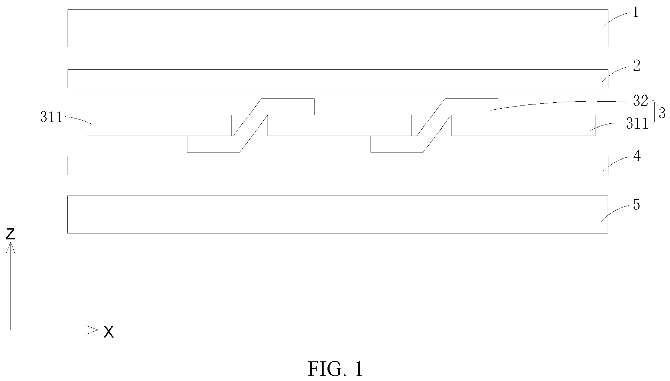

Embodiments of the present disclosure provide a photovoltaic module. As shown in FIG. 1, the photovoltaic module includes a front packaging structure, a back packaging structure, and a cell array 3. The front packaging structure includes a front plate 1 and a front packaging layer 2. The back packaging structure includes a back plate 5 and a back packaging layer 4. The cell array 3 includes a plurality of solar cells 311. Along a length direction X of the photovoltaic module, there is a cell distance L1 between two adjacent solar cells 311. In some embodiments, L1 satisfies 0 mm<L1≤1 mm. The cell array 3 further includes leads 32. The cell array 3 may include multiple solar cell strings, and each string including multiple solar cells 311 connected in series by the leads 32. For example, the multiple solar cell strings may be connected in parallel, and each solar cell string may include 11 or 12 solar cells connected in series.

The lead 32 is conductive. The lead 32 may also be referred to as an interconnect member or a wiring member. The lead 32 includes a core layer, and a coating layer coated over an outer surface of the core layer. The core layer is constituted by a wire having excellent electrical conductivity or the like, to substantially transfer current. The coating layer may have various functions for protecting the core layer or enhancing attachment characteristics of the lead. For example, the coating layer may include a solder material and, as such, may function to easily attach the lead to the solar cell in accordance with melting thereof by heat. Thus, the lead 32 may be easily attached to the solar cell in accordance with soldering through application of heat after the lead is disposed on the pad of the solar cell, without using a separate adhesive. Accordingly, a tabbing process may be simplified.

The lead 32 includes a first connection section 321, a flat section 322, and a second connection section 323 arranged sequentially along the length direction X of the photovoltaic module. The first connection section 321 is connected to the front surface of one solar cell 311, and the second connection section 323 is connected to the back surface of another solar cell 311 adjacent to the one solar cell 311. Along a thickness direction Z of the photovoltaic module, a thickness of the flat section 322 is less than the thickness of the first connection section 321 and is also less than the thickness of the second connection section 323. The flat section 322 is flattened. The flat section 322 may be also referred to as a thinned section. The flat section 322 has a first dimension L2 in the length direction X of the photovoltaic module, and 6≤L2:L1≤23.9.

In this embodiment, as shown in FIG. 1, the front packaging layer 2, the cell array 3, and the back packaging layer 4 are sandwiched between the front plate 1 and the back plate 5, and a photovoltaic module is formed through lamination and packaging. The front packaging layer 2 is configured to protect a light incidence surface of the cell array 3 (a side surface of the cell array 3 that faces a light source and receive direct sunlight, for example the front surface). The back packaging layer 4 protects an opposite surface of the cell array 3 (a surface of the cell array 3 that is away from the light source and receives sunlight reflected from the ground, for example the back surface). During lamination of the photovoltaic module, the front packaging layer 2 and the back packaging layer 4 are configured to package and protect the cell array 3 to prevent an influence of an external environment on performance of the cell array 3. In addition, the front plate 1, the back plate 5, and the cell array 3 are adhered by the front packaging layer 2 and the back packaging layer 4 into an entirety.

The front plate 1 and the back plate 5 may be made of rigid materials such as tempered glass, Polyethylene Terephthalate (PET), and Polycarbonate (PC) or made of flexible materials such as Polyvinyl Fluoride (PVF), Ethylene-Tetra-Fluoro-Ethylene (ETFE), and Polyvinylidene Fluoride (PVDF). The front packaging layer 2 and the back packaging layer 4 are adhesive films. The adhesive films may be made of materials such as Ethylene-Vinyl Acetate Copolymer (EVA), Polyolefin Elastomer (POE), and Polyvinyl Butyral (PVB). The front packaging layer 2 and the back packaging layer 4 may alternatively be an EPE adhesive film (EVA-POE-EVA co-extrusion structure) or an EP adhesive film (EVA-EP co-extrusion structure).

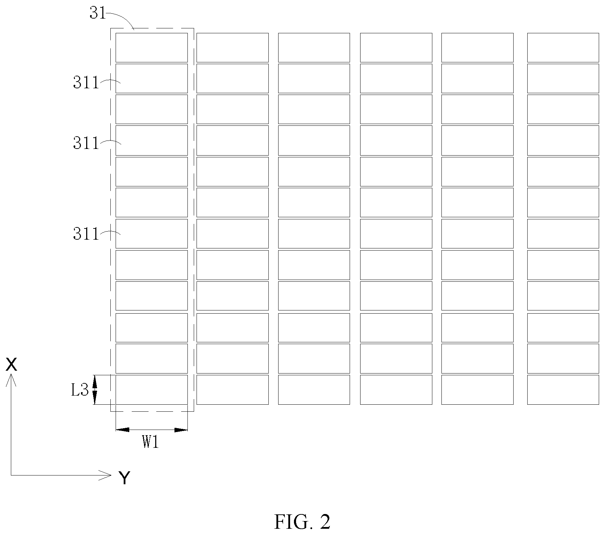

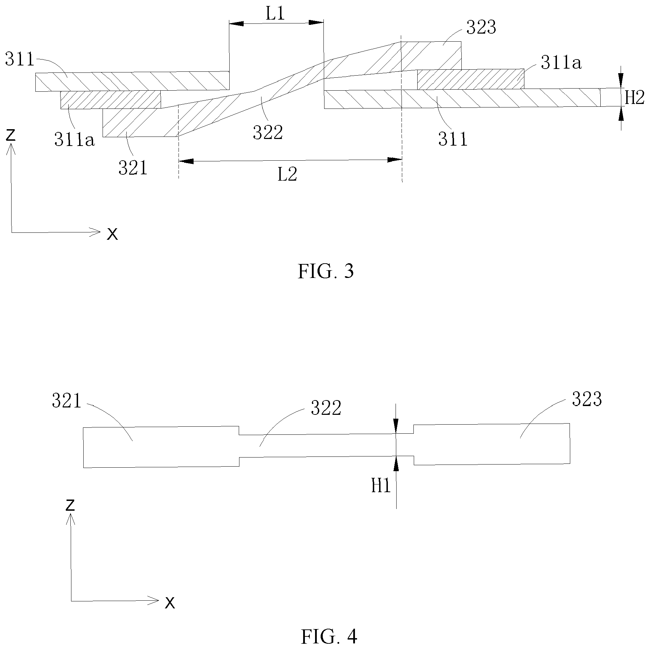

For example, as shown in FIG. 2, the cell array 3 includes a plurality of solar cells 311 arranged in an array. Along the length direction X of the photovoltaic module, the plurality of solar cells 311 are arranged at intervals to form solar cell strings 31 extending along the length direction X of the photovoltaic module. A plurality of solar cell strings 31 are arranged at intervals along a width direction Y of the photovoltaic module. Referring to FIG. 3 together, in one solar cell string 31, there is a cell distance L1 between two adjacent solar cells 311, and L1 satisfies 0 mm<L1≤1 mm, L1 may be, for example, 0.1 mm, 0.2 mm, 0.3 mm, 0.4 mm, 0.5 mm, 0.6 mm, 0.7 mm, 0.8 mm, 0.9 mm, or 1 mm, or may be other values in the above range, and is not limited in this embodiment.

During manufacturing of the photovoltaic module, the solar cell 311 may expand affected by the material of the solar cell 311, and the solar cell 311 may also undergo a certain displacement along the length direction X of the photovoltaic module due to factors such as a vacuuming step in a lamination process or flowing of the materials of the front packaging layer 2 and the back packaging layer 4. When a length of the photovoltaic module is fixed, if the cell distance L1 is 0 mm, there is no gap between the two adjacent cells 311. If the two solar cells come into contact, a short circuit easily occurs in the photovoltaic module. During lamination of the photovoltaic module, two adjacent solar cells 311 may even be misaligned and overlapped, causing cracking in the solar cell 311. When the length of the photovoltaic module is fixed, if the cell distance L1 is excessively large (e.g., greater than 1 mm), a dimension of the solar cell 311 in the length direction X of the photovoltaic module may be limited. As a result, an effective light incidence (light-receiving) area of the photovoltaic module is smaller, which affects power generation per unit area of the photovoltaic module, resulting in lower photoelectric conversion efficiency of the photovoltaic module. Therefore, along the length direction X of the photovoltaic module, the cell distance L1 between two adjacent solar cells 311 should satisfy 0 mm<L1≤1 mm, preferably 0.3 mm to 0.8 mm, which can prevent short circuit of the photovoltaic module and ensure a yield of the photovoltaic module and improving the photoelectric conversion efficiency of the photovoltaic module.

As shown in FIG. 3, in one solar cell string 31, two adjacent solar cells 311 are connected through the lead 32. Each of the solar cells 311 includes busbar electrodes and finger electrodes, and the busbar electrodes are connected to the finger electrodes. Currents collected by the finger electrodes may flow to the busbar electrodes and be outputted outside from the busbars through the lead 32. Along the length direction X of the photovoltaic module, an end portion of the busbar electrode is provided with a harpoon structure. The harpoon structure may extend to an edge region of the solar cell 311, and can collect currents at an edge of the solar cell 311, thereby achieving greater utilization of energy.

In this embodiment, the harpoon structure is provided with an edge pad 311a. Along the length direction X of the photovoltaic module, at least part of the first connection section 321 is soldered with the edge pad 311a on the opposite surface of one solar cell 311, and at least part of the second connection section 323 is soldered with the edge pad 311a on the light incidence surface of another solar cell 311 adjacent one solar cell 311, so that the two adjacent cells 311 are connected in series through the lead 32. In this case, at least part of the flat section 322 is located at a gap between the two adjacent solar cells 311. Referring to FIG. 4 together, since the thickness of the flat section 322 is less than the thickness of the first connection section 321 and the thickness of the second connection section 323, along the thickness direction Z of the photovoltaic module, there is a gap between the flat section 322 and an end portion of each of the two adjacent solar cells 311. In this way, the flat section 322 can avoid the end portion of the solar cell 311 (the flat section 322 and the end portion of the solar cell 311 are spaced apart), thereby preventing the lead 32 from affecting the end portion of the solar cell 311. Moreover, a damage risk to the end portion of the solar cell 311 due to stress concentration during the lamination of the photovoltaic module and a cracking possibility of the solar cell 311 are reduced, thereby improving the yield of the photovoltaic module. Moreover, in this embodiment, the cell distance L1 between two adjacent solar cells 311 is less than the cell distance in the conventional art, in which the solar cell 311 and the lead 32 may interfere each other. The arrangement of the flat section 322 of the lead 32 is more suitable for a layout with a smaller cell distance L1.

For example, as shown in FIG. 3, the flat section 322 has a first dimension L2 in the length direction X of the photovoltaic module, and 6≤L2:L1≤23.9. A value of the ratio L2:L1 may be, for example, 6, 6.5, 7.2, 8.9, 10.3, 11.5, 12.4, 13.8, 15, 16.8, 17.6, 19, 20.6, 21.8, 22.5, or 23.9, or other values in the above range, which is not limited in this embodiment.

When the cell distance L1 between two adjacent solar cells 311 is fixed, if L2:L1 is excessively small (e.g., less than 6), the dimension of the flat section 322 in the length direction X of the photovoltaic module may be excessively small, while the dimension of the first connection section 321 and/or the dimension of the second connection section 323 in the length direction X of the photovoltaic module is excessively large. Due to the excessively large thicknesses of the first connection section 321 and the second connection section 323, the first connection section 321 and/or the second connection section 323 may interfere with the end portion of the solar cell 311 in the thickness direction Z of the photovoltaic module, which easily causes damages to the solar cell 311. If L2:L1 is excessively large (e.g., greater than 23.9), the dimension of the flat section 322 in the length direction X of the photovoltaic module may be excessively large, while the dimension of the first connection section 321 and/or the dimension of the second connection section 323 in the length direction X of the photovoltaic module is excessively small, which results in a reduction in an area of connection between the first connection section 321 and/or the second connection section 323 and the edge pad 311a, thereby causing a reduction in reliability of a connection between the lead 32 and the edge pad 311a and easily affecting electrical connection performance between the two adjacent solar cells 311.

Therefore, when L2:L1 satisfies 6≤L2:L1≤23.9, interference of the lead 32 with the end portion of the solar cell 311 can be prevented, the solar cell 311 is protected from damages, and reliability of a connection between the lead 32 and the solar cell 311 is not affected, which increases a yield and power of the photovoltaic module.

In some embodiments, as shown in FIG. 4, along the thickness direction Z of the photovoltaic module, the thickness of the flat section 322 is H1, and H1 satisfies 0.05 mm≤H1≤0.26 mm, H1 may be, for example, 0.05 mm, 0.08 mm, 0.1 mm, 0.13 mm, 0.16 mm, 0.19 mm, 0.22 mm, 0.25 mm, or 0.26 mm, or other values in the above range, and is not limited in this embodiment.

In this embodiment, since the thickness of the lead 32 is 0.26 mm, that is, the thicknesses of the first connection section 321 and the second connection section 323 are both 0.26 mm, the thickness H1 of the flat section 322 is required to be less than 0.26 mm. If H1 is excessively small (e.g., less than 0.05 mm), the flat section 322 may be excessively thin and prone to breakage, which may affect an electrical connection between two adjacent cells 311, thereby reducing the power of the photovoltaic module. Therefore, when H1 satisfies 0.05 mm≤H1≤0.26 mm, a stable connection between the solar cells 311 can be ensured, which increases the power of the photovoltaic module.

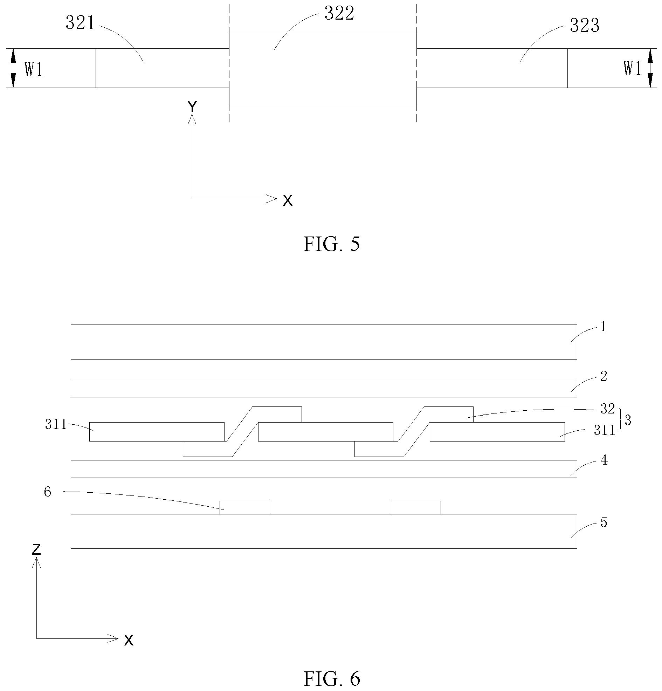

In some embodiments, as shown in FIG. 5, along the width direction Y of the photovoltaic module, the width of the first connection section 321 and/or the width of the second connection section 323 is W1, and W1 satisfies 0.22 mm≤H1≤0.26 mm, W1 may be, for example, 0.22 mm, 0.223 mm, 0.23 mm, 0.235 mm, 0.24 mm, 0.246 mm, 0.25 mm, 0.254 mm, or 0.26 mm, or other values in the above range, and is not limited in this embodiment.

When W1 is excessively small (e.g., less than 0.22 mm), the width of the first connection section 321 and/or the width of the second connection section 323 is excessively small, resulting in an excessively small area of connection between the lead 32 and the edge pad 311a, which may affect the stability of the connection between the lead 32 and the solar cell 311. When W1 is excessively large (e.g., greater than 0.26 mm), the width of the first connection section 321 and/or the width of the second connection section 323 is excessively large, resulting in an excessively large light-blocking area of the solar cell 311, which reduces sunlight incident the back plate 5 and may affect photoelectric conversion efficiency of the solar cell 311. Therefore, when W1 satisfies 0.22 mm≤H1≤0.26 mm, the stability of the connection between the lead 32 and the solar cell 311 can be ensured, and blocking of the sunlight can also be reduced, so that photoelectric conversion efficiency of the photovoltaic module is improved.

In addition, as shown in FIG. 5, the flat section 322 is obtained by flattening a partial region of the lead 32. Therefore, a width of the flat section 322 is greater than a width of the first connection section 321 and/or a width of the second connection section 323.

A length of the photovoltaic module generally ranges from 2380 mm to 2384 mm. In the conventional art, the solar cells in the photovoltaic module are square solar cells. That is, a length and a width of the solar cell range from 177 mm to 187 mm. Along the length direction X of the photovoltaic module, a cell distance between two adjacent cells is 1.5 mm. In this case, due to the large cell distance, there may be more blank space in the layout of the photovoltaic module, which results in a smaller effective light-receiving area of the photovoltaic module, thereby resulting in small power generation per unit area of the photovoltaic module and low overall power.

In some embodiments, as shown in FIG. 2, the solar cell 311 is a half-cut cell, and along the length direction X the photovoltaic module, the length of the solar cell 311 is L3, and L3 satisfies: 95 mm≤L3≤110 mm, L3 may be, for example, 95 mm, 97 mm, 99 mm, 101 mm, 103 mm, 105 mm, 107 mm, 109 mm, or 110 mm, or other values in the above range, and is not limited in this embodiment. Along the width direction Y of the photovoltaic module, a width of the solar cell 311 is W2, and W2 satisfies 177 mm≤W2≤187 mm, W2 may be, for example, 177 mm, 178 mm, 179 mm, 180 mm, 181 mm, 182 mm, 183 mm, 184 mm, 185 mm, 186 mm, or 187 mm, or other values in the above range, and is not limited in this embodiment.

The solar cell 311 in this embodiment is a rectangular half-cut cell. The length L3 of the solar cell 311 ranges from 95 mm to 110 mm, and the width W2 of the solar cell 311 ranges from 177 mm to 187 mm. Compared with the solar cell in the conventional art, the solar cell 311 has a larger dimension along the length direction X of the photovoltaic module and can be arranged with a smaller cell distance L1. When the solar cell 311 with the above dimension is used, that is, the reduced size of the cell distance L1 is compensated to the solar cell 311 if the length of the photovoltaic module is fixed. That is, the length L3 of the solar cell 311 is increased. Compared with the conventional art, the effective light-receiving area of the solar cell 311 can be increased, thereby improving power generation per unit area of the photovoltaic module and improving photoelectric conversion efficiency of the photovoltaic module.

In some embodiments, as shown in FIG. 3, along the thickness direction Z of the photovoltaic module, the thickness of the solar cell 311 is H2, and H2 satisfies 80 µm≤H2≤125 µm, H2 may be, for example, 80 µm, 83 µm, 89 µm, 95 µm, 101 µm, 108 µm, 116 µm, 121 µm, or 125 µm, or other values in the above range, and is not limited in this embodiment.

When the thickness H2 of the solar cell 311 is excessively small (e.g., less than 80 µm), structural strength of the solar cell 311 may be insufficient. During the lamination of the photovoltaic module, the solar cell 311 is prone to cracking, resulting in a low yield of the photovoltaic module. When the thickness H2 of the solar cell 311 is excessively large (e.g., greater than 125 µm), the cost of the photovoltaic module may be increased, and interference between the solar cell 311 and the lead 32 easily occurs, causing damages to the end portion of the solar cell 311 due to stress concentration. Therefore, when H2 ranges from 80 µm to 125 µm, a risk of damages to the solar cell 311 can be reduced, and the manufacturing cost of the photovoltaic module is reduced.

The present disclosure does not limit the structure of the solar cell 311. Types of the solar cell 311 include, but are not limited to, a passivated emitter and rear contact (PERC) solar cell, a tunnel oxide passivated contact (TOPCon) solar cell, a heterojunction (HJT) solar cell, and an interdigitated back contact (IBC) solar cell.

The PERC solar cell includes a front electrode arranged on a front surface and made of metallic silver, a front passivation layer made of silicon nitride, a phosphorus-doped emitter, a P-type base silicon layer, a local aluminum back field layer, a back electrode made of metallic aluminum, and a back passivation layer (Al₂O₃/SiNₓ) sequentially along a thickness direction. The PERC solar cell uses a passivation film to passivate the back surface, which replaces an all-aluminum back field layer, enhances internal back reflection of light on a silicon base, reduces a recombination rate on the back surface, and increases efficiency of the solar cell by 0.5% to 1%.

The TOPCon solar cell includes an electrode made of metallic silver, a front passivation layer made of silicon nitride, a boron-doped emitter, an N-type base silicon layer, a diffusion doped layer, a ultra-thin silicon oxide layer, a doped polysilicon layer, a silicon nitride layer, and an electrode made of metallic silver sequentially along a thickness direction. The back surface of the solar cell is composed of a layer of ultra-thin silicon oxide (1 nm to 2 nm) and a layer of phosphorus-doped mixed microcrystalline-amorphous Si film, which together form a passivated contact structure. The structure may block recombination of minority-carrier holes and increase an open-circuit voltage and a short-circuit current of the solar cell. The ultra-thin oxide layer allows multi-carrier electrons to tunnel into the polysilicon layer and block recombination of minority-carrier holes. A good passivation effect of ultra-thin silicon oxide and heavily doped silicon films causes a surface energy band of a silicon substrate to bend, thereby forming a field passivation effect. A probability of electron tunneling is greatly increased, and contact resistance is reduced, which increases the open-circuit voltage and the short-circuit current of the solar cell, thereby improving conversion efficiency of the solar cell.

The HJT solar cell includes a front low-temperature silver electrode, a front conductive film, an N-type amorphous silicon film, an intrinsic amorphous silicon film, an N-type base silicon layer, an intrinsic amorphous silicon film, a P-type amorphous silicon film, a back conductive film, and a back low-temperature silver electrode sequentially along a thickness direction.

The IBC solar cell includes a silicon nitride layer, an N+ front surface field layer, an N-type base silicon layer, a P+ emitter, an N+ back field layer, an aluminum oxide passivation layer, a silicon nitride anti-reflection layer, and a metallic silver electrode sequentially along a thickness direction. The IBC cell uses an ion implantation technology to obtain P and N regions with good uniformity and accurately controllable junction depths, and there is no electrode shielding the front surface of the solar cell, which can eliminate light-shielding current losses due to metal electrodes and maximize utilization of incident photons, and can increase the short-circuit current by about 7% compared with the conventional solar cell. Due to the back contact structure, there is no need to consider the electrode shielding problem, and a width of the electrode can be appropriately increased, thereby reducing series resistance and increasing the fill factor. Surface passivation and surface light-trapping structures can be optimally designed to obtain a lower front-surface recombination rate and surface reflection.

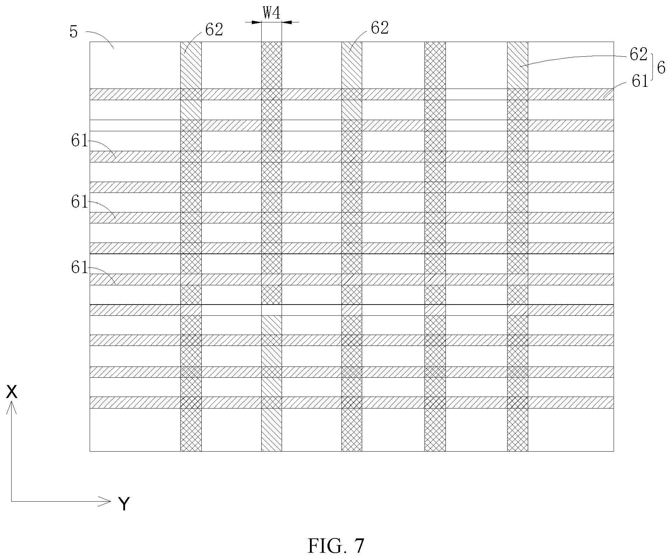

In some embodiments, both the front plate 1 and the back plate 5 are made of glass. As shown in FIG. 6 and FIG. 7, the photovoltaic module further includes a strip 6, and the strip 6 includes a first strip 61 and a second strip 62. Along the thickness direction Z of the photovoltaic module, the first strip 61 is aligned with a gap between the two solar cells 311 adjacent in the length direction X of the photovoltaic module, and the second strip 62 is aligned with a gap between the two solar cells 311 adjacent in the width direction Y of the photovoltaic module.

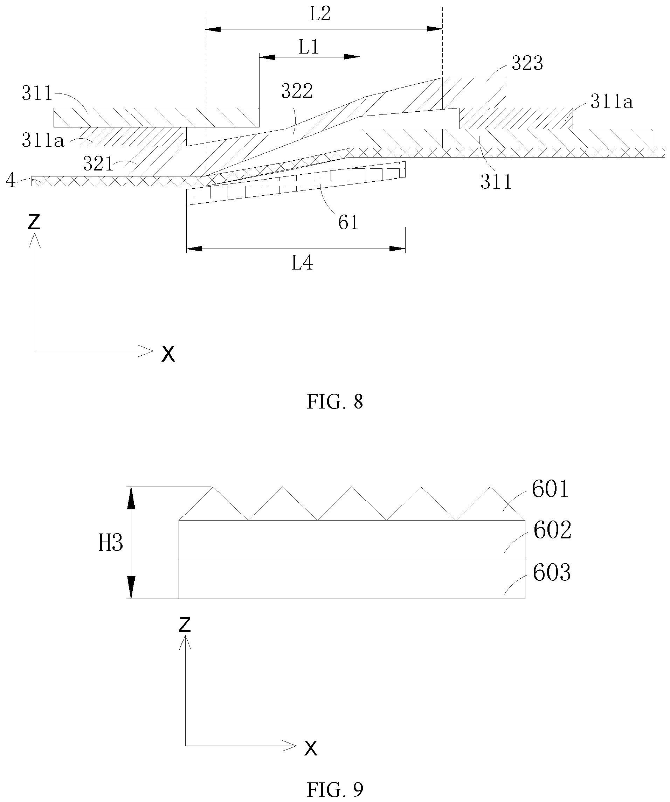

When the photovoltaic module has a double-glass structure, the front packaging layer 2 and the back packaging layer 4 are also made of transparent materials. In this case, the strip 6 may be arranged in the photovoltaic module. The strip 6 is configured to reflect sunlight and improve utilization of the sunlight by the photovoltaic module, thereby improving the photoelectric conversion efficiency of the photovoltaic module. For example, there is a gap between two solar cell strings 31 adjacent in the width direction Y of the photovoltaic module. A width W3 of the gap is a string distance of the solar cell strings 31. The second strip 62 is configured to cover the string distance in the thickness direction Z of the photovoltaic module, and a width W4 of the second strip 62 is greater than the string distance W3. In this embodiment, the string distance W3 is 1.5 mm. Therefore, the width W4 of the second strip 62 is greater than 1.5 mm. As shown in FIG. 8, a gap between two solar cells 311 adjacent in the length direction X of the photovoltaic module is a cell gap. The first strip 61 is configured to cover the cell gap in the thickness direction Z of the photovoltaic module, a length of the cell gap is the cell distance L1, the first strip 61 has a second dimension L4 in the length direction X of the photovoltaic module, and L4 is greater than L1.

For example, as shown in FIG. 8 and FIG. 9, along the thickness direction Z of the photovoltaic module, the strip 6 includes a reflective layer 601, a base layer 602, and an adhesive layer 603 arranged sequentially. The adhesive layer 603 is bonded and fixed to an inner surface of the back plate 5.

The reflective layer 601 is an aluminum reflective layer. As shown in FIG. 8, a surface of the reflective layer 601 has a wavy structure (uneven structure) for reflecting light of the light source, and an aluminum material has good reflective properties, which can greatly improve a reflection capability of the strip 6. The adhesive layer 603 is made of EVA and is configured to be bonded and fixed to the front plate 1 or the back plate 5. The base layer 602 is a PET layer, which mainly supports the reflective layer 601 and the adhesive layer 603.

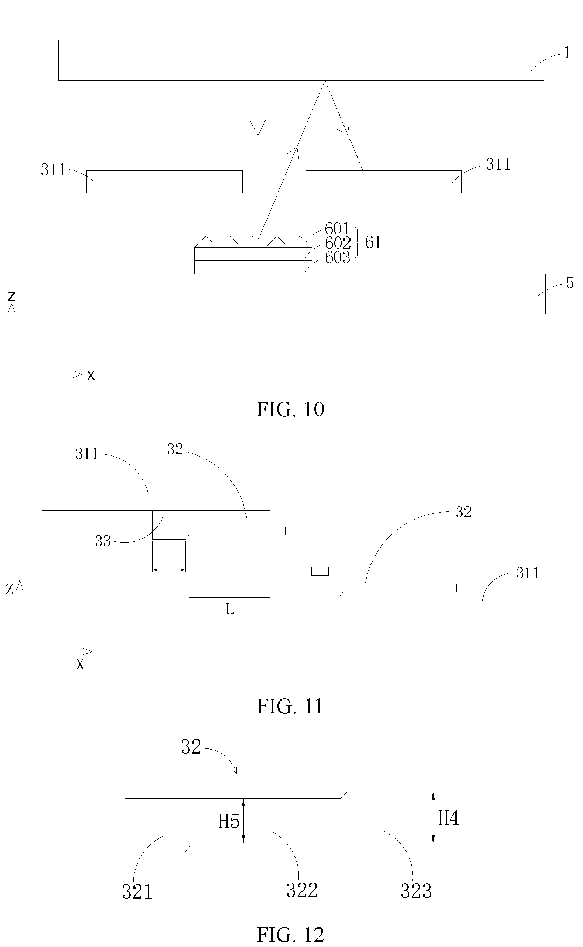

As shown in FIG. 10, the adhesive layer 603 of the first strip 61 is adhered to the back plate 5, and the reflective layer 601 of the first strip 61 faces the light source. When the sunlight is incident through the front plate 1, a wavy structure of the reflective layer 601 can reflect light between the two adjacent solar cells 311 to the front plate 1 and cause the light to be totally reflected by the front plate 1, thereby reflecting the light back to the light-facing surface of the solar cell 311, which improves utilization of the reflected light at the cell gap by the solar cell 311. Similarly, the adhesive layer 603 of the second strip 62 is adhered to the back plate 5, and the reflective layer 601 of the second strip 62 can improve utilization of the reflected light at the string gap by the solar cell 311.

Therefore, through the arrangement of the first strip 61 and the second strip 62, unused sunlight that passes the string gap and the cell gap can be reflected, so that these light can be used by the solar cell 311, thereby improving the efficiency of the solar cell 311 and improving the photoelectric conversion efficiency of the photovoltaic module.

In this embodiment, description is based on an example in which both the first strip 61 and the second strip 62 are adhered to the back plate 5 through a film sticking machine, and the adhesive layers 603 of the first strip 61 and the second strip 62 are bonded and fixed to the inner surface of the back plate 5. However, in some other embodiments, along the thickness direction Z of the photovoltaic module, the first strip 61 may be arranged at a position on the front plate 1 corresponding to the cell gap, and the second strip 62 may be arranged at a position on the front plate 1 corresponding to the string gap, which can also reflect light, so as to further improve utilization of reflection at the cell gap and the string gap by the solar cell 311. A specific adhering position of the strip 6 is not limited in the present disclosure.

In some embodiments, a ratio of the second dimension L4 to the cell distance L1 satisfies 5.38≤L4:L1≤6.25, which may be, for example, 5.38, 5.42, 5.48, 5.53, 5.64, 5.78, 5.9, 6.12, 6.19, or 6.25, or other values in the above range, and is not limited in this embodiment.

When the cell distance L1 between two adjacent solar cells 311 is fixed and the ratio L4:L1 is excessively small (e.g., less than 5.38), the dimension of the first strip 61 in the length direction X of the photovoltaic module may be excessively small. If the solar cell 311 is offset from the target position during the lamination, it cannot ensure that the first strip 61 can still completely cover the cell gap, which may also lead to a reduction in the utilization of the sunlight by the photovoltaic module. When the ratio L4:L1 is excessively large (e.g., greater than 6.25), the cost of the first strip 61 may be increased, but the utilization of the sunlight by the photovoltaic module is not obviously improved. Therefore, when the ratio of the second dimension L4 to the cell distance L1 satisfies 5.38≤L4:L1≤6.25, the utilization of the sunlight by the photovoltaic module can be improved, and the manufacturing cost of the photovoltaic module can be appropriately reduced.

In some embodiments, as shown in FIG. 8, in the length direction X of the photovoltaic module, the second dimension L4 of the first strip 61 and the first dimension L2 of the flat section 322 satisfy: L4<L2.

In this embodiment, if L4>L2, along the thickness direction Z of the photovoltaic module, an edge of the first strip 61 is prone to interference with the lead 32. As a result, protective films of the two and the back packaging layer 4 located therebetween are pierced, leading to short circuit of the solar cell 311 caused by an electrical connection between the first strip 61 and the lead 32, which may even affect the overall quality of the photovoltaic module. Therefore, the second dimension L4 of the first strip 61 should be less than the first dimension L2 of the flat section 322. In this way, in the thickness direction Z of the photovoltaic module, the flat section 322 can avoid the edge of the first strip 61 and prevent risks of piercing the back packaging layer 4 and then piercing the first strip 61 by the flat section 322 during the lamination of the photovoltaic module, thereby ensuring the yield of the photovoltaic module.

In this embodiment, the second dimension L4 of the first strip 61 preferably ranges from 4 mm to 6 mm, L4 may be, for example, 4 mm, 4.3 mm, 4.8 mm, 5.2 mm, 5.7 mm, or 6 mm, or other values in the above range, and is not limited in this embodiment. The first dimension L2 of the flat section 322 preferably ranges from 6 mm to 14 mm, L2 may be, for example, 6 mm, 7 mm, 8 mm, 9 mm, 10 mm, 11 mm, 12 mm, 13 mm, or 14 mm, or other values in the above range, and is not limited in this embodiment.

In some embodiments, along the thickness direction Z of the photovoltaic module, a thickness of the first strip 61 is H3, and H3 satisfies 80 µm≤H3≤140 µm, H3 may be, for example, 80 µm, 85 µm, 91 µm, 97 µm, 105 µm, 112 µm, 123 µm, 130 µm, 138 µm, or 140 µm, or other values in the above range, and is not limited in this embodiment.

In this embodiment, when H3 is excessively small (e.g., less than 80 µm), the thickness of the first strip 61 is excessively thin and manufacturing is inconvenient, which may increase process difficulty and the manufacturing cost of the photovoltaic module. When H3 is excessively large (e.g., greater than 140 µm), a risk of interference between the first strip 61 and the lead 32 along the thickness direction Z of the photovoltaic module may be increased. Therefore, the thickness H3 of the first strip 61 should range from 80 µm to 140 µm, which can reduce a risk of short circuit of the solar cell 311 caused by interference between the first strip 61 and the lead 32 and can also appropriately reduce the manufacturing cost of the photovoltaic module. Based on the above, in the present disclosure, the solar cell 311 is manufactured using rectangular cell, which can achieve an effect of reducing the cell distance L 1 and increase the effective light-receiving area of the photovoltaic module, thereby improving the photoelectric conversion efficiency of the photovoltaic module. Through the arrangement of the strip 6 on the back plate 5, the utilization of the sunlight by the solar cell 311 can be improved. Through the arrangement of the flat section 322 on the lead 32 and corresponding thinning of the first strip 61, interference of the lead 32 with the first strip 61 or the solar cell 311 can be prevented, which reduces risks of cracking and short circuit of the solar cell 311, thereby ensuring the quality of the photovoltaic module.

As shown in FIG. 11, in some embodiments, the photovoltaic module includes solar cells 311 and leads 32. The solar cells 311 are rectangular. Each of the solar cells 311 includes a front surface and a back surface opposite to each other. The lead 32 is connected to two adjacent solar cells 311. The lead 32 has a first end connected to the front surface of one solar cell 311 of two adjacent solar cells 311 and a second end connected to the back surface of the other solar cell 311 of two adjacent solar cells 311. The lead 32 includes a flat section 322, a first connection section 321 and a second connection section 323 located at two ends of the flat section 322. A thickness of the flat section 322 in a thickness direction Z is less than a thickness of the first connection section 321 and a thickness of the second connection section 323. Overlapping parts of the solar cells 311 form an overlapping region, and a dimension of the flat section 322 in the length direction X is greater than or equal to that of the overlapping region.

A plurality of solar cells 311 sequentially overlap with each other along the thickness direction Z to form a step structure. In actual use, the solar cell 311 may tilt relatively, and the lead 32 can deform accordingly, so that when the lead 32 is connected to the solar cell 311, the plurality of solar cells 311 can form an inclined step shape, which facilitates reduction of the overall thickness of the photovoltaic module. Through the control over the shape of the lead 32, the solar cells 311 may have an appropriate tilt angle during overlapping and lamination. Therefore, when the solar cells 311 are laminated, lamination stress in the overlapping region of the solar cells 311 is transferred to a non-overlapping region of the solar cells 311, bending moment in the non-overlapping region of the solar cells 311 may not be excessively large, which can further reduce problems such as bending deformation or cracking of the solar cells 311 due to the excessively large bending moment and further prolong the overall service life of the photovoltaic module.

Further, the photovoltaic module may be further provided with an adhesive film. Since the overall thickness of the overlapping region where the lead 32 is arranged is relatively thick, the solar cell 311 is easily subjected to greater stress when laminated. For example, the solar cells 311 in the overlapping region on two sides of the lead 32 may tend to move closer to each other along the thickness direction of the photovoltaic module, causing bending deformation of the solar cells 311 in the overlapping region where the lead 32 is not arranged, thereby leading to easy bending deformation and even cracking of the solar cells 311. The adhesive film may be arranged in the overlapping region and fill a region between the solar cells 311 and on two sides of the lead 32. During the lamination, forces on the solar cells 311 in the overlapping region can be more uniform, which enables the solar cells 311 to maintain balance, thereby reducing reliability of problems such as cracking. For example, the adhesive film may be slightly thinner in the overlapping region at a position of the lead 32 and may be slightly thicker in the overlapping region on the two sides of the lead 32, so that thicknesses of a region supported by the lead 32 and a region not supported by the lead 32 are relatively balanced and forces on a part of the solar cell 311 supported by the lead 32 and a part not supported by the lead 32 are more balanced. In fact, during the lamination, the melted adhesive film has certain fluidity, which can have a better filling effect on the overlapping region of the solar cell 311.

The solar cells 311 partially overlap with each other, which can improve the overall operating efficiency of the photovoltaic module. The lead 32 and the solar cells 311 arranged overlappingly provided in some embodiments of the present disclosure have matching structures. For example, the flat section 322 is located in an overlapping region where the solar cells 311 overlap with each other, and the overlapping region has less space in the thickness direction Z. Therefore, the thickness of the flat section 322 in the thickness direction Z is less than the thicknesses of the first connection section 321 and the second connection section 323, which can reduce a possibility of cracking or fragmentation in the overlapping region. The thicknesses of the first connection section 321 and the second connection section 323 located at two ends of the flat section 322 are greater than the thickness of the flat section 322, the larger thickness makes the volume larger, and an area of connection with the solar cell 311 is also larger, which facilitates the connection between the lead 32 and the solar cell 311 and improves reliability of the connection between the lead 32 and the solar cell 311. Therefore, the photovoltaic module provided in embodiments of the present disclosure can reduce a failure possibility of the solar cell 311.

In some embodiments, the photovoltaic module further includes a cover plate. The cover plate is located on at least one side of the solar cell 311. The cover plate has stronger mechanical strength than the solar cell 311. Since an operating environment of the photovoltaic module is generally outdoors, wind, sand, rain, and snow in a natural environment may cause damages to the solar cell 311, and the cover plate is configured to protect the solar cell 311. Moreover, the cover plate has good light transmittance, which reduces light blocking and reduces the influence on power generation efficiency of the photovoltaic module. For example, the cover plate may be made of glass. The cover plate and the solar cell 311 may be interconnected by an adhesive film, thereby reducing a possibility of relative displacement of the cover plate relative to the solar cell 311.

The above adhesive film may be made of Polyethylene vinylacetate (EVA). The adhesive film made of EVA can play a bonding and fixing role and has good light transmittance, which can reduce the influence on the power generation efficiency of the photovoltaic module. In addition, the adhesive film may alternatively be made of a material such as Polyolefin thermoplastic elastomer (POE) or Polyethylene terephthalate (PET).

As shown in FIG. 12, in some embodiments, the thicknesses of the first connection section 321 and the second connection section 323 in the thickness direction Z are H4, and 0.35 mm≤H4≤0.4 mm, for example, 0.35 mm, 0.37 mm, 0.4 mm, or the like.

As shown in FIG. 12, in some embodiments, a thickness of the flat section 322 in the thickness direction Z is H5, and 0.1 mm≤H5≤0.2 mm, such as 0.1 mm, 0.15 mm, or 0.2 mm.

As shown in FIG. 11, in some embodiments, the solar cell 311 has pads 33, and the first connection section 321 and the second connection section 323 are connected to the pads 33.

The first connection section 321 and the second connection section 323 are configured to be connected to the pads 33. Shapes of cross sections of the first connection section 321 and the second connection section 323 are circles or ellipses. The thicknesses of the first connection section 321 and the second connection section 323 in the thickness direction Z are greater than the thickness of the flat section 322, which facilitates the connection with the pads 33, can reduce a possibility of low-temperature soldering, and can also reduce the difficulty of soldering of the lead 32. The cross sections of the first connection section 321 and the second connection section 323 have a circular or elliptic structure as a whole. If the thickness is excessively large, a risk of fragmentation of the solar cell 311 may be increased, and a usage amount of the adhesive film may be increased, which is not conducive to cost control. In some embodiments of the present disclosure, specific thicknesses of the first connection section 321 and the second connection section 323 are given to achieve a reasonable balance among soldering reliability, the service life, and the manufacturing cost of the photovoltaic module.

As shown in FIG. 11, in some embodiments, a dimension of the overlapping region in the length direction X is L, and 0<L≤1 mm.

In the photovoltaic module provided in some embodiments of the present disclosure, the specific dimension of the overlapping region in the length direction X is given, and an area of overlapping of the solar cells 311 can be controlled according to the dimension of the overlapping region, so that the solar cells 311 can be stably connected to each other. On the other hand, the light-receiving area of the solar cell 311 affects the power generation efficiency thereof, and the area of the overlapping region may not be excessively large to lead to excessively low power generation efficiency of the solar cell 311. The specific dimension of the overlapping region may be further adjusted according to the dimension of the solar cell 311, and the solar cell 311 in the overlapping region may be subjected to stress generated by lamination during the lamination. Therefore, a distance from an edge of a lamination region to an edge of the solar cell 311 is taken into account. In some embodiments of the present disclosure, the dimension of the overlapping region in the length direction of the photovoltaic module is given, and an overall area of the overlapping region can be controlled in conjunction with the specific dimension of the solar cell 311. For example, in a case where the dimension of the solar cell 311 is fixed, when the dimension of the overlapping region in the length direction X is small, the overall area of the overlapping region is further controlled to be small, and due to mutual blocking of the solar cells 311 in the overlapping region, the light-receiving area of the solar cell 311 may be reduced, thereby affecting overall operating efficiency of the photovoltaic module. When the area of the overlapping region is small, the influence of the overlapping region on the power generation efficiency of the photovoltaic module can be further reduced. On the other hand, a distance from an edge of the overlapping region and an edge of the solar cell 311 may be longer, and an area of the non-overlapping region may be larger, so pressure on the non-overlapping region may be smaller during the lamination, which reduces the problem of cracking of the solar cell 311 in the non-overlapping region due to excessively large pressure.

Certain bending deformation can occur on a surface of the non-overlapping region under greater stress, so that the solar cells 311 can be laminated without cracking when arranged overlappingly. When the pressure is fixed and a dimension of the non-overlapping region in the width direction Y is larger, the dimension of the overlapping region in the width direction Y accounts for a small proportion of the overall dimension of the solar cell 311, so that there may be more space to adjust and set a range of the overlapping region.

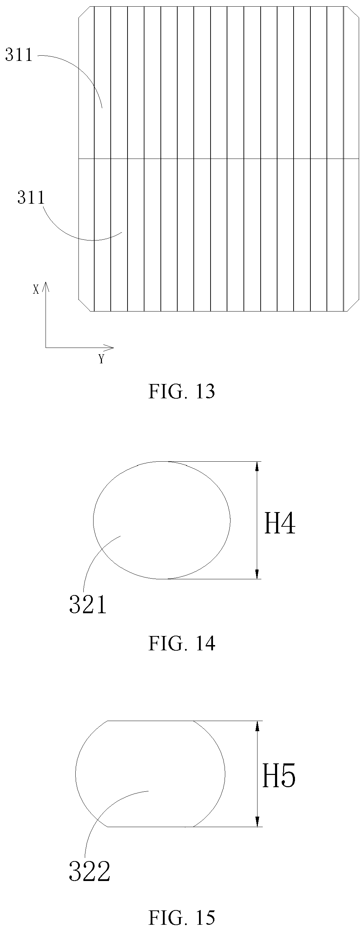

As shown in FIG. 13, in some embodiments, the solar cell 311 has a dimension ranging from 180 mm to 185 mm in the width direction Y, and a dimension ranging from 93 mm to 97.5 mm or from 102.5 mm to 110 mm in the length direction X.

The solar cell 311 in some embodiments of the present disclosure is obtained by cutting a complete (mother) solar cell into two half-cut solar cells. A dimension of the complete solar cell 311 in the width direction Y ranges from 180 mm to 185 mm, and a dimension of the complete solar cell in the length direction X ranges from 186 mm to 195 mm or from 205 mm to 220 mm. When the complete solar cell 311 is cut along the width direction Y, two half-cut solar cells with a same size can be obtained. For ease of description, the solar cells 311 formed by cutting are collectively referred to as solar cells 311. A conventional complete solar cell is a square with same dimensions in the width direction Y and the length direction X, and half-cut solar cells formed by cutting have smaller dimensions, which is not conducive to improving overall power generation power of the photovoltaic module. The area of the solar cell 311 provided in some embodiments of the present disclosure is larger than that of the conventional solar cell 311, which can improve power generation of the photovoltaic module.

The dimensions of the solar cells 311 in the width direction Y and the length direction X may also affect the lamination stress. For example, in the width direction Y, the solar cells 311 are subjected to the lamination stress, the solar cells 311 in the overlapping region on two sides of the lead 32 along the width direction Y may deform, and when the dimensions of the solar cells 311 along the width direction Y are larger, the solar cells 311 require less stress to produce sufficient bending deformation, and possibilities of cracking and fragmentation are relatively small. In the length direction X, when the solar cells 311 are subjected to the lamination stress, the non-overlapping region of the solar cells 311 may bend and deform, and when the dimensions of the solar cells 311 in the length direction X are larger, it is relatively easy for the solar cells 311 to produce sufficient bending deformation, and possibilities of cracking and fragmentation are relatively small.

In some embodiments, a dimension of the photovoltaic module in the length direction X ranges from 2380 mm to 2384 mm.

According to the photovoltaic module provided in some embodiments of the present disclosure, the overall size of the photovoltaic module can be controlled by controlling the dimensions, the quantity, and the layout manner of the solar cells 311 and through the design of related matching dimensions such as gaps and creepage distances between the solar cells 311, so that the dimension of the photovoltaic module in the length direction X can match a dimension of a relevant standard container and space utilization of the container can be improved during packing and transporting of the photovoltaic module.

In some embodiments, a dimension of the flat section 322 in the width direction Y ranges from 2 mm to 20 mm.

The flat section 322 can completely cover the overlapping region in the width direction Y, and can cooperate with the solar cells 311 in the overlapping region of the solar cells 311, so that the lead 32 can achieve a thinning effect in the overlapping region, thereby reducing the failure possibility such as cracking of the solar cells 311.

As shown in FIG. 14 and FIG. 15, in some embodiments, a side of the flat section 322 in contact with the solar cell 311 is a flat surface.

As shown in FIG. 15, the flat section includes a flat top surface, a flat bottom surface opposite to the flat top surface, a first curved side surface, and a second curved side surface opposite to the first curved side surface.

A cross section of the lead 32 after machining and manufacturing is generally a circle or an ellipse, through further machining, a partial region may be flattened to form the flat section 322, the thickness of the flat section 322 is less than the thicknesses of the first connection section 321 and the second connection section 323 that are not flattened, and two sides of the flat section 322 have flat surfaces to facilitate abutment against the solder cells 311. A cross section of the flat section 322 may be in a shape of a rectangle, a trapezoid, a semicircle, or the like, and the cross section has a flat surface along the thickness direction of the photovoltaic module. Compared with a curved surface, the flat surface can increase an area of contact between the lead 32 and the solar cell 311, which can reduce pressure on the solar cell 311 during the lamination and reduce a possibility of cracking or other failures in the solar cell 311. Moreover, flat-surface contact increases friction between the lead 32 and the solar cell 311, reduces a possibility of rolling or sliding displacement of the lead 32, and enables the lead 32 to be maintained at a relatively appropriate position relative to the solar cell 311. The flat surface of the flat section 322 may be on two sides of the lead 32 along the thickness direction of the photovoltaic module or only one side. For example, in the overlapping region, the two sides of the lead 32 are laminated by the solar cells 311. Therefore, flat surfaces may be provided on the two sides to facilitate abutment against the solar cells 311 to increase the contact area, thereby reducing the pressure. When the flat section 322 is at edges of two ends of the lead 32, the flat surface on one side of the flat section 322 in contact with the solar cell 311 may extend to the first connection section 321 or the second connection section 323, so that the first connection section 321 and the second connection section 323 can have a larger contact area with the solar cell 311, thereby facilitating the connection of the lead 32. The other sides of the first connection section 321 and the second connection section 323 may be curved surfaces, so that the first connection section 321 and the second connection section 323 have larger dimensions in the thickness direction of the photovoltaic module and the first connection section 321 and the second connection section 323 have larger volumes, thereby facilitating soldering of the first connection section 321 and the second connection section 323.

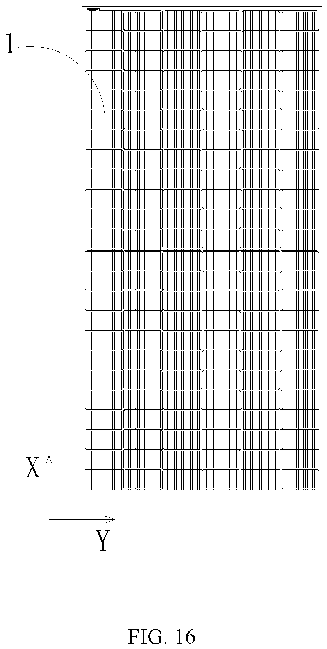

As shown in FIG. 16, in some embodiments, 6 solar cells 311 are arranged at intervals along the width direction Y, and 11 or 12 solar cells 311 are arranged overlappingly along the length direction X. The arrangement of the solar cells 311 affects the overall dimension and size of the photovoltaic module. Through reasonable setting of the arrangement of the solar cells 311, the shape and the size of the photovoltaic module can be made more reasonable, thereby facilitating packaging and transportation.

The present disclosure provides a photovoltaic module. The photovoltaic module includes solar cells 311 and leads 32. Each of the solar cells 311 is rectangular, with a dimension in a length direction X greater than a dimension in a width direction Y The solar cell 311 includes a front surface and a back surface opposite to each other. The lead 32 is connected to two adjacent solar cells 311. The lead 32 has one end connected to the front surface of one solar cell 311 of two adjacent solar cells 311 and the other end connected to the back surface of the other solar cell 311 of two adjacent solar cells 311. The lead 32 includes a flat portion 322, and a first connection section 321 and a second connection section 323 located at two ends of the flat portion 322. A thickness of the flat portion 322 in a third direction Z is less than that of the first connection section 321 and the second connection section 323. Overlapping parts of the solar cells 311 form an overlapping region, and a dimension of the flat section 322 in the length direction X is greater than or equal to that of the overlapping region, thereby reducing a possibility of damages to the solar cells 311.

The present disclosure provides a photovoltaic module. The photovoltaic module includes solar cells 311 and leads 32. The solar cells are arranged with a preset gap or are arranged overlapping with one another. A shape of the lead 32 is adapted to arrangement of the solar cells 311. The lead 32 is provided with a flat section 322 avoiding the solar cells 311, thereby reducing a possibility of damages to the solar cells 311 and improving overall quality of the photovoltaic module.

The above descriptions are only preferred embodiments of the present disclosure, and are not intended to limit the present disclosure. For those skilled in the art, various modifications and changes may be made to the present disclosure. Any modifications, equivalent replacements, improvements, and the like made within the principle of the present disclosure shall fall within the protection scope of the present disclosure.

## Claims

1. A photovoltaic module, comprising:
a front packaging structure comprising a front plate (1) and a front packaging layer (2);
a back packaging structure comprising a back plate (5) and a back packaging layer (4); and
a cell array (3) comprising a plurality of solar cells (311), wherein each of the plurality of solar cells (311) is rectangular and comprises a front surface and a back surface opposite to each other, wherein the cell array (3) further comprises leads (32), each lead (32) comprises a first connection section (321), a flat section (322), and a second connection section (323) arranged sequentially along a length direction of the photovoltaic module, the first connection section (321) is connected to the front surface of one of two adjacent solar cells (311) of the plurality of solar cells (311), and the second connection section (323) is connected to the back surface of the other one of the two adjacent solar cells (311),
wherein, along a thickness direction of the photovoltaic module, a thickness of the flat section (322) is less than a thickness of either of the first connection section (321) and the second connection section (323), and
a cell distance L1 between two adjacent solar cells (311) satisfies 0 mm<L1≤1 mm, and a ratio of a first dimension L2 of the flat section (322) in the length direction of the photovoltaic module to the cell distance L1 satisfies 6≤L2:L1≤23.9, or the adjacent solar cells (311) overlap each other to form an overlapping region, and a dimension of the flat section (322) in the length direction of the photovoltaic module is greater than or equal to that of the overlapping region.

2. The photovoltaic module according to claim 1, wherein, along the thickness direction of the photovoltaic module, the thickness H1 of the flat section (322) satisfies 0.05 mm≤H1<0.26 mm, or a dimension of the flat section (322) in a width direction of the photovoltaic module ranges from 2 mm to 20 mm.

3. The photovoltaic module according to claim 1, wherein the thickness of the first connection section (321) and the thickness of the second connection section (323) in the thickness direction of the photovoltaic module are both greater than or equal to 0.35 mm and less than or equal to 0.4 mm.

4. The photovoltaic module according to claim 1, wherein, along a width direction of the photovoltaic module, either a width of the first connection section (321) or the second connection section (323) is greater than or equal to 0.22 mm and less than 0.26 mm.

5. The photovoltaic module according to claim 1, wherein each solar cell (311) is a half-cut cell, and along the length direction of the photovoltaic module, and a length L3 of each solar cell (311) satisfies: 95 mm≤L3≤110 mm, and
along a width direction of the photovoltaic module, a width W2 of each solar cell (311) satisfies 177 mm≤W2≤187 mm.

6. The photovoltaic module according to claim 1, wherein, along the thickness direction of the photovoltaic module, a thickness H2 of the solar cell (311) satisfies 80 µm≤H2≤125 µm.

7. The photovoltaic module according to any one of claims 1 to 6, wherein both the front plate (1) and the back plate (5) are made of glass, the photovoltaic module further comprises a strip (6), and the strip (6) comprises a first strip (61) and a second strip (62), and
along the thickness direction of the photovoltaic module, the first strip (61) is aligned with a gap between two solar cells (311) adjacent in the length direction of the photovoltaic module, and the second strip (62) is aligned with a gap between two solar cells (311) adjacent in the width direction of the photovoltaic module.

8. The photovoltaic module according to claim 7, wherein along the length direction of the photovoltaic module, the first strip (61) has a second dimension L4, and a ratio L4:L1 satisfies: 5.38≤L4:L1≤6.25.

9. The photovoltaic module according to claim 8, wherein the second dimension L4 and the first dimension L2 satisfy: L4<L2.

10. The photovoltaic module according to claim 7, wherein, along the thickness direction of the photovoltaic module, a thickness H3 of the first strip (61) satisfies 80 µm≤H3≤140 µm.

11. The photovoltaic module according to claim 7, wherein, along the thickness direction of the photovoltaic module, the strip (6) comprises a reflective layer (601), a base layer (602), and an adhesive layer (603) arranged sequentially, and wherein the adhesive layer (603) is adhered to an inner surface of the back plate (5).

12. The photovoltaic module according to any one of claims 1 to 6, wherein each solar cell (311) comprises pads (33), and the first connection section (321) and the second connection section (323) are connected to the pads (33) of adjacent solar cells (311).

13. The photovoltaic module according to any one of claims 1 to 6, wherein the plurality of solar cells (311) overlap with one another, and a dimension L of the overlapping region in the length direction of the photovoltaic module satisfies 0<L≤1 mm.

14. The photovoltaic module according to claim 13, wherein a side of the flat section (322) in contact with the solar cell (311) is a flat surface.

15. The photovoltaic module according to claim 14, wherein 6 solar cells (311) of the plurality of solar cells (311) are arranged at intervals along the width direction of the photovoltaic module, and 11 or 12 solar cells (311) of the plurality of solar cells (311) are arranged overlapping with one another along the length direction of the photovoltaic module.
